# EUROPEAN PATENT SPECIFICATION

(11) **EP 4 426 090 B1**
(45) Date of publication and mention of the grant of the patent: **06.08.2025**
(21) Application number: 23158995.3
(22) Date of filing: 28.02.2023
(51) Int. Cl.: H10N 50/01, H10N 50/10, H10N 50/85, H10B 61/00

(54) **A STACK WITH A HIGH TUNNELING MAGNETORESISTANCE RATIO FOR A MAGNETIC RANDOM ACCESS MEMORY DEVICE**
STAPEL MIT HOHEM TUNNELMAGNETWIDERSTANDSVERHÄLTNIS FÜR EINE MAGNETISCHE DIREKTZUGRIFFSSPEICHERVORRICHTUNG
EMPILEMENT A RAPPORT DE MAGNETORESISTANCE A EFFET TUNNEL ELEVE POUR DISPOSITIF DE MEMOIRE A ACCES ALEATOIRE MAGNETIQUE

(43) Date of publication of application: 04.09.2024
(73) Proprietor: Imec VZW, 3001 Leuven (BE)
(72) Inventor: MERTENS, Sofie, 3018 Wijgmaal (BE); SANKARAN, Kiroubanand, 3020 Herent (BE); PIAO, Xiaoyu, 3001 Heverlee (BE); CARPENTER, Robert, 3010 Kessel-lo (BE)
(74) Representative: Roth, Sebastian

(56) References cited:
- US-A1- 2007 258 170
- US-A1- 2017 309 301
- US-A1- 2020 266 333
- US-B2- 9 490 054

## Description

### TECHNICAL FIELD

The present disclosure is related to magnetic random access memory (MRAM) devices, and magnetic tunnel junctions (MTJs) employed in such MRAM devices. The disclosure presents a stack for an MRAM device, for example, for a spin-transfer torque (STT) MRAM device, wherein the stack includes a perpendicular or in-plane MTJ with an enhanced tunneling magnetoresistance ratio (TMR). The disclosure also presents an MRAM device, and a method for fabricating the stack for the MRAM device.

### BACKGROUND

MRAM devices, for example, perpendicular STT-MRAM devices, include a perpendicular MTJ. Typically, the MTJ comprises a magnetic free layer and a magnetic fixed reference layer, which are separated by a tunnel barrier layer. The free layer of the MTJ is used to store information, and the stored information can be read-out by determining a tunneling magnetoresistance between the free layer and the reference layer through the tunnel barrier layer. For example, the reference layer and the free layer may be made of a cobalt iron boron (CoFeB) material, and the tunnel barrier layer of magnesium oxide (MgO), in order to optimize a switching current and the TMR, respectively.

However, conventional stacks for MRAM devices, which are based on such MTJs, deliver a TMR ≤200% at a resistance area product (RA) < 10 and a TMR ≤ 250% at RA > 10. The low TMR and a low RA remain the main limiting factors, for example, for STT-MRAM devices.

Therefore, a higher TMR of above 200% is required at RA < 10 to broaden its application by increasing, for instance, a write or erase margin, or to reduce read or sensing errors.

An improved crystallinity of the MgO tunnel barrier layer, as well as an improved interface quality of the layers, could increase the TMR in the above-described MTJ. However, in conventional stacks, a high thermal budget of 400 °C and more during fabrication will still result in an undesired TMR reduction. This is, because the high thermal budget leads to a loss of perpendicular magnetic anisotropy (PMA) in the free layer and/or the reference layer, and may also cause a significant diffusion of metal elements through the stack, which may deteriorate the properties of the free layer and/or the reference layer.

The use of a "MTJ first" approach, wherein the reference layer is arranged on top of the stack (also referred to as a top-pinned stack in this disclosure), may show some improvement. However, challenges with back end of line (BEOL) processing can exist in such a stack, for instance, due to high annealing temperatures experience by the stack.

The use of a synthetic ferromagnetic (SFM) pinning layer may provide the stack with some annealing tolerance of, for example, up to 400 °C in a top-pinned stack. This may increase the TMR, however, a TMR of 200% or more at RA < 10 can still not be achieved.

US 2007/0258170 A1 shows a (001) ordered Fe/MgO/Fe MTJ on a MgO substrate with a MgO (001) seed layer.

US 9 490 054 B2 shows a MTJ with a free layer over a seed layer on a substrate including a lower electrode.

US 2020/0266333 A1 shows a post-deposition annealing step to achieve (100) structure in a MgO barrier layer.

### SUMMARY

In view of the above, this disclosure aims for an improved stack for an MRAM device, and an improved method for fabricating the stack. An objective is to reach a higher TMR in such a stack than in a conventional stack, in particular, a TMR of ≥ 200% at RA < 10 and/or a TMR ≥ 250% at RA > 10. An objective is specifically to improve the TMR by a top-pinned stack design.

These and other objectives are achieved by the solution of the present invention provided in the independent claims. Advantageous implementations are defined in the dependent claims.

A first aspect of this disclosure provides a stack for a MRAM device, the stack comprising: a substrate layer having a [001] or [010] or [100] in-plane texture; a first electrode layer arranged on the substrate layer, the first electrode layer having a [001] or [010] or [100] in-plane texture; a seed metal layer arranged on the first electrode layer the seed metal layer having a [001] or [010] or [100] in-plane texture; a magnetic free layer arranged on the seed metal layer; a crystalline tunnel barrier layer arranged on the free layer; a magnetic reference layer arranged on the crystalline tunnel barrier layer; a pinning layer arranged on the reference layer; and a second electrode layer arranged on the pinning layer.

Due to the above-described in-plane textures of the substrate layer, the first electrode layer, and the seed metal layer, respectively, the TMR of the stack can be improved, and can reach values of 200% and higher. Notably, in this disclosure, the TMR is the ratio of a first tunneling magnetoresistance and a second tunneling magnetoresistance experienced when tunneling through the crystalline tunnel barrier layer. The first tunneling magnetoresistance relates to the case where the free layer and the reference layer have opposite (anti-parallel) magnetization orientations, and the second tunneling magnetoresistance relates to the case where the free layer and the reference layer have the same (parallel) magnetization orientations. The switchable magnetization of the free layer may represent stored information, while the magnetization of the reference layer is fixed.

The TMR increase may specifically be achieved, because an [001] or [010] or [100] in-plane texture of the free layer is obtained as well. As a further consequence, the quality of the crystalline tunnel barrier layer can be also improved, which enhances the TMR of the stack.

A very high quality of the crystalline tunnel barrier layer may be achieved by annealing during the fabrication of the stack, specifically after the tunnel barrier layer is formed and before the reference layer is formed, as described in more detail later. The enhanced crystallinity of the tunnel barrier layer increases the TMR for the stack. The tunnel barrier layer may notably also have a [001] or [010] or [100] in-plane texture.

The stack of the first aspect is a top-pinned stack, since the reference layer is arranged above the free layer, wherein "above" is defined along a direction away from the substrate layer in this disclosure. That is, a first layer that is arranged "above" or "on" (meaning directly on in this disclosure) a second layer, is more distanced from the substrate layer than the second layer. The direction away from the substrate layer may be referred to as the stacking direction of the layers of the stack, or may be referred to as a vertical direction (as illustrated in the exemplary figures), and may be perpendicular to the surfaces of the layers of the stack.

In an implementation of the stack, the substrate layer comprises at least one of a magnesium oxide layer, a magnesium-oxide-based layer, and a [001] or [010] or [100] in-plane conductive or dielectric layer; and the conductive or dielectric layer comprises at least one of a magnesium titanium oxide layer, a magnesium titanate layer, a magnesium dititanate layer, a magnesium gallate layer, and a nickel aluminide layer.

For instance, the substrate layer may consist of one or more magnesium based alloys. The substrate layer may, beneficially, act as a template for providing the [001] or [010] or [100] in-plane texture to the further layers of the stack. Thus, the substrate layer may also be referred to as template layer in this disclosure.

In an implementation of the stack, the first electrode layer comprises at least one of a titanium nitride layer, a chromium layer, a tantalum nitride layer.

In an implementation of the stack, the seed metal layer comprises at least one of a tungsten layer, a molybdenum layer, a niobium nitride layer, and a tantalum layer.

In an implementation of the stack, at least one of the free layer and the reference layer comprises an iron-based layer; and/or at least one of the free layer and the reference layer comprises at least one of the following: one or more iron layers; one or more iron boron layers; one or more cobalt iron boron layers; one or more cobalt iron layers; one or more cobalt iron carbon layers; one or more cobalt iron carbon boron layers; one or more cobalt boron layers.

The material selection and/or process of fabrication of the first electrode layer, the seed layer, and/or the free layer, respectively, may be beneficial for several reasons. For instance, the selected materials may support a well-defined in-plane texture and higher quality of the free layer. Further, the selected materials may allow the use of higher thermal budgets during the fabrication of the stack, which may lead to a better quality of the crystalline tunnel barrier layer, and may improve the PMA of the free layer.

In an implementation of the stack, the free layer comprises at least two layers with respectively an amorphising dopant, wherein the two layers have different contents of the amorphising dopant. In addition, the two layers may have different types of amorphising dopants, for instance, selected from boron, carbon, or both.

For example, a higher boron content in the free layer may be beneficial to reach a higher TMR after a (e.g., high temperature) thermal treatment, which is performed after forming the tunnel barrier layer and before forming the reference layer, since crystallization of the tunnel barrier layer is delayed. On the other hand, a lower boron content may be beneficial in the reference layer, in order to allow a lower thermal budget after fabricating the full stack, and thus to reach higher TMR. In an implementation, it is also possible to use no boron at all in the reference layer and/or to use another amorphising dopant.

Two layers (e.g., a double-layer) are beneficial for both the free layer and the reference layer. For instance, a first layer of the double-layer may be made of pure iron, while a second layer of the double-layer may be a magnetic alloy with a lattice match [± 5%] with an MgO or MgO-based alloy. The amorphising dopant type and content might be different for the free layer and the reference layer.

In an implementation of the stack, the free layer has a [001] or [010] or [100] in-plane texture; and/or the free layer comprises one or more spacer material layers to enhance the [001] or [010] or [100] in-plane texture and/or to act as diffusion barrier.

This in-plane texture of the free layer improves the quality of the tunnel barrier layer, hence, further improves the TMR.

In an implementation of the stack, the crystalline tunnel barrier layer has a [001] or [010] or [100] in-plane texture; and/or an interface between the crystalline tunnel barrier layer and the free layer is formed by a magnesium-oxide-layer to an iron-layer interface.

This may lead to a further improved TMR of the stack.

In an implementation of the stack, the free layer and the reference layer have each a thickness in a range of 0.1-3.0 nanometer; and/or the seed metal layer has a thickness in a range of 0.05-100 nanometer; and/or the substrate layer has a thickness in a range of 0.05-200 nanometer; and/or the first electrode layer has a thickness in a range of 1-200 nanometer; and/or the crystalline tunnel barrier layer has a thickness in a range of 0.5-5 nanometer.

These thicknesses and dimensions have proven to be beneficial for increasing the TMR of the stack.

In an implementation of the stack, the pinning layer comprises a synthetic antiferromagnet (SAF) layer, and optionally comprises a spacer layer arranged on the reference layer.

The SAF layer and spacer layer can be annealed at lower safe anneal temperatures that reduces eventual metal diffusion through the stack, and PMA loss of the reference layer.

A second aspect of this disclosure provides an MRAM device comprising one or more stacks, wherein each stack is designed according to the stack of the first aspect or any implementation of the first aspect.

The MRAM device of the second aspect enjoys the advantages of the stack of the first aspect. The improved TMR of the stack enhances the performance of the MRAM device.

A third aspect of this disclosure provides a method for fabricating a stack for an MRAM device, the method comprising: forming a substrate layer having a [001] or [010] or [100] in-plane texture; forming a first electrode layer on the substrate layer, the first electrode layer having a [001] or [010] or [100] in-plane texture; forming a seed metal layer on the first electrode layer, the seed metal layer having a [001] or [010] or [100] in-plane texture; forming a magnetic free layer on the seed metal layer; forming a tunnel barrier layer on the free layer; performing a first anneal at a temperature in a range of 400-500 °C or higher, whereby the tunnel barrier layer becomes crystalline; forming a magnetic reference layer on the crystalline tunnel barrier layer, after performing the first anneal; forming a pinning layer on the reference layer; and forming a second electrode layer on the pinning layer.

The method of the third aspect can be used to fabricate a stack, which enjoys all the advantages described above with respect to the stack of the first aspect. The method may accordingly fabricate a stack with a higher TMR than that of a conventional stack.

The method enables decoupling thermal budgets during the fabrication of the stack. For example, a higher thermal budget can be provided by performing the first anneal, after the tunnel barrier layer is formed and before the reference layer is formed. A lower thermal budget anneal can be performed at a later stage of the fabrication method. The first anneal leads to a crystalline and/or higher quality tunnel barrier layer, which enhances the TMR of the stack. The first anneal may specifically obtain a [001] or [010] or [100] in-plane textured crystalline tunnel barrier layer, which is, for example, made from MgO. This also means that the reference layer can be deposited on a high-quality crystalline tunnel barrier layer, which has additional benefits with respect to the TMR.

Conventional stacks are fabricated using one anneal after fabricating the whole stack. In such stacks, a tunnel barrier crystallization may not occur at all or with lower quality due to not optimal texture, and may happen only during annealing the full stack, impacting also the reference layer and the free layer, which lowers the TMR. Further, in a conventional top-pinned stack the reference layer will be deposited on an amorphous tunnel barrier layer.

In an implementation, the method further comprises performing a second anneal at a temperature in a range of 300-400 °C or lower, after forming the second electrode layer.

The second anneal may use a lower temperature than the first anneal. The thermal budgets of the two anneals are decoupled in the method. While the higher thermal budget of the first anneal may lead to an improved crystalline quality of the tunnel barrier layer as explained above, the lower thermal budget second anneal may avoid PMA loss in the reference layer and/or the free layer, and may also prevent metal diffusion through the stack.

In an implementation, the method further comprises performing a third anneal after forming the seed layer and before forming the free layer.

This third anneal may further improve the TMR of the stack.

In an implementation of the method, the stack is designed according to any implementation of the stack of the first aspect. Accordingly, the method can be used to fabricate the stack according to the first aspect as such or any of its implementations.

In summary, this disclosure addresses a significant challenge of conventional MRAM devices and conventional stacks for MRAM devices, for example, for STT-MRAM devices, namely the hard TMR/RA limits that can be reached with the conventional stacks and their fabrication methods. The MTJ first approach is employed in this disclosure, and based thereon a method is provided to decouple the maximum thermal budgets for the MTJ on the one hand side (comprising the seed layer, the free layer, and the tunnel barrier layer), and the reference layer, the pinning layer on the other hand side (e.g., the SAF layer).

Improvements of the in-plane textures of the first electrode layer, the seed metal layer, and the free layer, and an enhanced thermal stability of these layers, allow setting the framework for an improved quality and/or crystallinity of the crystalline tunnel barrier layer, which may be achieved by the first anneal. Overall, the TMR of the MTJ of the stack can thus be significantly improved to values beyond 200%.

### BRIEF DESCRIPTION OF THE DRAWINGS

The above described aspects and implementations are further explained in the following description of exemplar embodiments with respect to the drawings, wherein:
- FIG. 1: shows a stack for an MRAM device according to this disclosure.
- FIG. 2: shows a method for fabricating a stack for an MRAM device according to this disclosure.
- FIG. 3: compares a solution (stack and method) of this disclosure with an exemplary solution.
- FIG. 4: shows in (a) a TEM image of a stack on different first electrodes with the MTJ first approach of this disclosure; and shows in (b) an XRD analysis of an MgO substrate layer, a first electrode layer, and an iron layer of a stack of this disclosure; and shows in (c) HR-TEM images comparing the MTJ first approach with a conventional bottom-pinned stack.

### DETAILED DESCRIPTION OF EMBODIMENTS

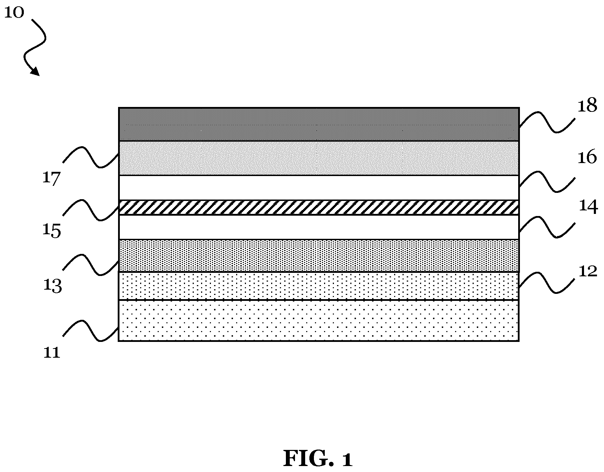

FIG. 1 shows a stack 10 for an MRAM device according to this disclosure. The MRAM device may comprise one or more such stacks 10. For instance, the MRAM device may include at least one such stack 10 for/in each memory cell of multiple memory cells of the MRAM device. The MRAM device of this disclosure may be a STT-MRAM device. Accordingly, the stack 10 may be for or of a STT-MRAM device.

The stack 10 comprises a substrate layer 11, a first electrode layer 12 provided on the substrate layer 11, and a seed metal layer 13 provided on the first electrode layer 12. These layers 11, 12, 13 each have a [001] or [010] or [100] in-plane texture.

The substrate layer 11 may be or comprise a conductive layer or a dielectric layer. For instance, the conductive or dielectric layer may comprise a magnesium titanium oxide layer (MgTi₂O₄ layer), a magnesium titanate layer (MgTiO₃layer), a magnesium dititanate layer (MgAl₂O₄ layer), a magnesium gallate layer (MgGa₂O₄ layer), or a nickel aluminide layer (NiAl layer). The substrate layer 11 may also be or comprise a magnesium oxide based layer, for example, a MgₓO_{y}X_{z} layer, wherein X is selected from the list of: Ti, V, Cr, Mn, Fe, Co, Ni, Cu, Zn, Zr, Nb, Mo, Tc, Ru, Rh, Pd, Ag, Cd, Hf, Ta, W, Re, Os, Ir, Pt, Au, Al, Ga, Ge, In, Sn, Sb, Pb, Bi, and wherein x, y and z are numbers. An example for the substrate layer 11 is (Mg_{0.2}Ti_{0.8})O.

The first electrode layer 12 may be or comprise a titanium nitride layer (TiN layer), a chromium layer (Cr layer), or a tantalum nitride layer (TaN layer).

The seed metal layer 13 may be or comprise a tungsten layer (W layer), a molybdenum layer (Mo layer), a niobium nitride layer (NbN layer), or a tantalum layer (Ta layer). It may have a function of seeding the next layer.

The stack 10 further comprises an MTJ, wherein the MTJ comprises a magnetic free layer 14 provided on the seed metal layer 13, a crystalline tunnel barrier layer 15 provided on the magnetic free layer 14, and a magnetic reference layer 16 provided on the crystalline tunnel barrier layer 15.

The free layer 14 and/or the reference layer 16 may each comprise at least one of the following: an iron layer (Fe layer), an iron boron layer (FeB layer), a cobalt iron boron layer (CoFeB layer), a cobalt iron layer (CoFe layer), a cobalt iron carbon layer (CoFeC layer), a cobalt iron carbon boron layer (CoFeCB layer), and a cobalt boron layer (CoB layer).

The tunnel barrier layer 15 may comprise a crystalline magnesium oxide layer (MgO layer) and/or magnesium based oxide layer. The crystalline tunnel barrier layer 15 may have a [001] or [010] or [100] in-plane crystal texture.

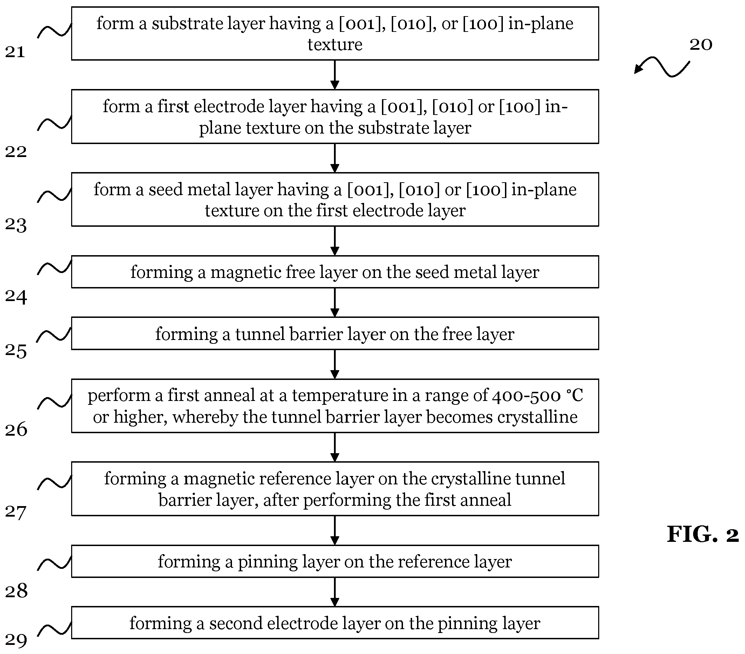

FIG. 2 shows a flow-diagram of a method 20 for fabricating a stack for an MRAM device according to this disclosure, in particular, for fabricating the stack 10 shown in FIG. 1. The method 20 comprises steps of forming the various layers of the stack 10 described above, in particular, the steps 22, 23, 24, 25, 27, 28 and 29. Beneficially, the method also comprises the step 26 of performing a first anneal at a temperature in a range of 400-500 °C or higher. As can be seen, the first anneal 26 is performed after forming the tunnel barrier layer 15, and before forming the reference layer 16. Due to this first anneal 26, the tunnel barrier layer 15 formed in step 25 becomes crystalline and/or is provided with an improved crystalline quality. This improves the TMR of the stack 10. The method 20 may comprise further steps of performing one or more additional anneals, as described later.

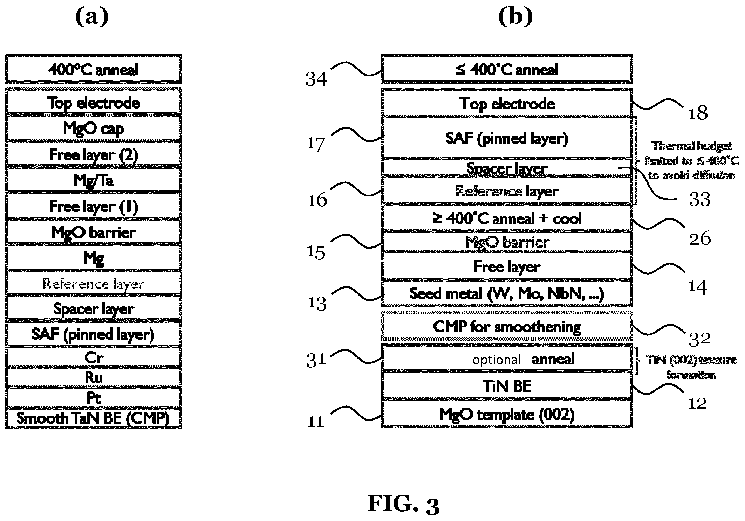

FIG. 3 shows a comparison of a conventional solution for stack in (a) and an exemplary solution of this disclosure for the stack 10 and method 20 in (b). The conventional solution is a bottom-pinned stack and suffers from high thermal budgets experienced by the entire stack. Also conventional top-pinned stacks suffer from high thermal budgets.

The exemplary stack 10 shown in FIG. 3(b) includes an MgO template layer as the substrate layer 11, which has a [002] in-plane texture that corresponds to a [001] in plane-texture, and includes a TiN bottom electrode (BE) layer as the first electrode layer 12, which is arranged on the substrate layer 11. After forming the first electrode layer 12 on the substrate layer 11, an optional anneal step may be performed. This optional anneal may be beneficial for the in-plane texture of the first electrode layer 12. Further, an optional chemical-mechanical polishing (CMP) step may be performed, which may reduce the roughness and thus enhance the quality of the following layers and the layer interfaces of the stack 10, thus also improving the TMR.

The exemplary stack 10 of FIG. 3(b) further includes the seed metal layer 13 (for example, comprising a W, Mo, or NbN layer) arranged on the first electrode layer 12, and potentially formed after performing the optional CMP step. The stack 10 further includes the magnetic free layer 14 (e.g., comprising a CoFeB layer or any material mentioned above) provided on the seed metal layer 13, and includes the tunnel barrier layer 15 made of MgO and/or MgO based oxide layer, which is arranged on the free layer 14. After forming the tunnel barrier layer 15, the first anneal step 26 also shown in FIG. 2 may be performed, for instance, at a temperature of 400 °C or more. Afterwards, the intermediate stack formed up to this point may be allowed to cool down, before forming the next layer(s). The cooldown allows avoiding diffusion during the later pinning layer deposition.

The exemplary stack 10 of FIG. 3(b) further includes the magnetic reference layer 16 (e.g., a CoFeB layer or any material mentioned above) provided on the MgO and/or MgO based oxide tunnel barrier layer 15 and formed after the first anneal 26, further includes a spacer layer 33 provided on the reference layer 16, further includes a SAF layer as the pinning layer 17, and finally includes the second electrode layer 18 (e.g., a TiN, TaN, Ta/Ru layer or another metal layer) provided on the pinning layer 17. After forming the pinning layer 18, a second anneal step 34 is performed at a temperature ≤ 400 °C, for example, in a range of 300-400 °C or lower. Due to the separation of the two anneal steps 26 and 34, the thermal budget experienced by the reference layer 16, the spacer layer 33, and the pinning layer 17 is limited. This may avoid that metals diffuse much and far in the stack 10, and may thus prevent the stack 10 from suffering performance loss due to TMR reduction. The thermal budget experienced by the tunnel barrier layer 15 is higher and promotes its crystallinity.

With the method(s) 20 and stack(s) 10 presented in this disclosure, a high TMR of 200% or more at a low RA of ~4.5 Ohms.µm2, or even 240% or more at a low RA of ~10 Ohm.µm2 may be obtained. The MTJ first approach (top-pinned stack) is used in this disclosure, and the maximum thermal budget for the tunnel barrier layer 15 of the MTJ (the first anneal 26) and respectively for the SAF pinning layer 17 (the second anneal 34) can be decoupled.

The first electrode layer 12, the seed layer 13, and the free layer 14 may be optimized by material selection and/or process of fabrication, in order to improve the TMR of the stack 10. For instance, the choice of the materials for the first electrode layer 12 and the seed layer 13, enables the forming of an improved free layer 14. For instance, an improved (Co)Fe [100] in-plane texture of the free layer 14 can be obtained. An improved free layer 14 results in an improved tunnel barrier layer quality (e.g., higher quality crystalline MgO), and thus a higher TMR. The choice of the materials for the seed layer 13 and the free layer 14 enables the higher thermal budgets of the first anneal step 26, while maintaining the PMA of the free layer. The high thermal budget enhances the tunnel barrier layer crystallization and its interfaces to the free layer 14 and reference layer 16, respectively, and consequently enhances the TMR. In addition, an improved breakdown and switching performance may be achieved due to the improved crystallinity of the tunnel barrier layer 15.

In the stacks 10 shown in FIG. 1 and FIG. 3(b), the layers may have the following thicknesses, wherein "thickness" in this disclosure is measured into the stacking direction of the layers of the stack 10. The free layer 14 and the reference layer 16 may respectively have a thickness in a range of 0.1-3.0 nanometer. The seed metal layer 13 may have a thickness in a range of 0.05-100 nanometer. The substrate layer 11 may have a thickness in a range of 0.05-200 nanometer. The first electrode layer 12 may have a thickness in a range of 1-200 nanometer. The crystalline tunnel barrier layer 15 may have a thickness in a range of 0.5-5 nanometer.

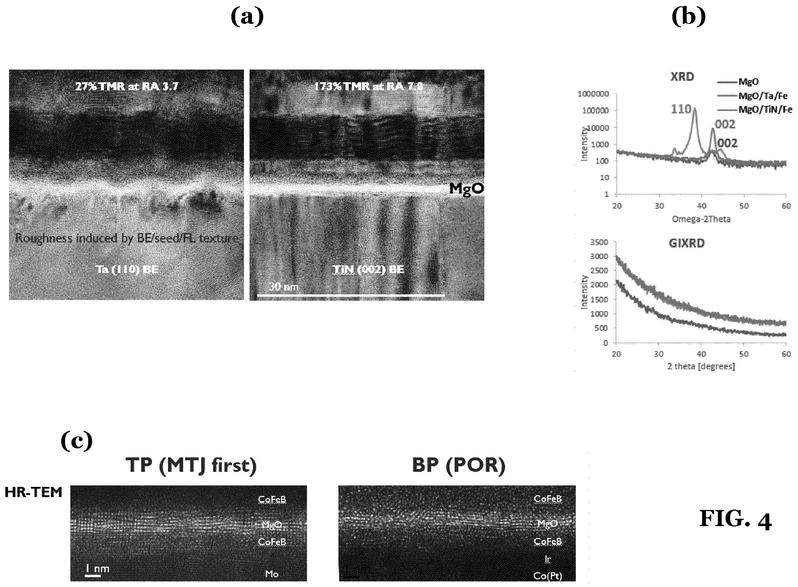

FIG. 4 shows in (a) transmission electron microscopy (TEM) images of MTJs of stacks, wherein the MTJs are formed on different (first) electrode layers after CMP, and wherein both stacks are formed with the MTJ first approach. The left-side TEM image is of a MTJ arranged on a Ta electrode having a [110] in-plane texture, while the right-side TEM image is of a MTJ arranged on a TiN electrode with a [002] in-plane texture as proposed by this disclosure. It can be seen that for the right-side case, the layers and interfaces of the stack are of much higher quality, which leads to higher TMR of the MTJ.

FIG. 4 shows further in (b) an XRD analysis of only an MgO substrate layer, of a stack comprising a Ta electrode layer on the MgO substrate layer and an iron layer on the Ta electrode layer, and a part of a stack 10 of this disclosure comprising a TiN electrode layer on the MgO substrate layer and an iron layer on the TiN electrode layer. For the improved textured first electrode layer a peak associated with a [002] in-plane texture is revealed. Notably, in each case the electrode layer was CMP smoothed, the iron layer has a 5 nanometer thickness.

FIG. 4 shows further in (c) high resolution TEM (HR-TEM) images, which demonstrate the improved MgO texture achieved with the MTJ first approach (left image) compared to the conventional bottom pinned stack (right image).

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A stack (10) for a magnetoresistive random-access memory, MRAM, device, the stack (10) comprising:
a substrate layer (11) having a [001] or [010] or [100] in-plane texture;
a first electrode layer (12) arranged on the substrate layer (11), the first electrode layer (12) having a [001] or [010] or [100] in-plane texture;
a seed metal layer (13) arranged on the first electrode layer (12), the seed metal layer (13) having a [001] or [010] or [100] in-plane texture;
a magnetic free layer (14) arranged on the seed metal layer (13);
a crystalline tunnel barrier layer (15) arranged on the free layer (14);
a magnetic reference layer (16) arranged on the crystalline tunnel barrier layer (15);
a pinning layer (17) arranged on the reference layer (16); and
a second electrode layer (18) arranged on the pinning layer (17).

2. The stack (10) of claim 1, wherein:
the substrate layer (11) comprises at least one of a magnesium oxide layer, a magnesium-oxide-based layer, and a [001] or [010] or [100] in-plane conductive or dielectric layer; and
the conductive or dielectric layer comprises at least one of a magnesium titanium oxide layer, a magnesium titanate layer, a magnesium dititanate layer, a magnesium gallate layer, and a nickel aluminide layer.

3. The stack (10) of claim 1 or 2, wherein the first electrode layer (11) comprises at least one of a titanium nitride layer, a chromium layer, a tantalum nitride layer.

4. The stack (10) of one of the claims 1 to 3, wherein:
the seed metal layer (13) comprises at least one of a tungsten layer, a molybdenum layer, a niobium nitride layer, and a tantalum layer.

5. The stack (10) of one of the claims 1 to 4, wherein:
at least one of the free layer (14) and the reference layer (16) comprises an iron-based layer; and/or
at least one of the free layer (14) and the reference layer (16) comprises at least one of the following:
- one or more iron layers;
- one or more iron boron layers;
- one or more cobalt iron boron layers;
- one or more cobalt iron layers;
- one or more cobalt iron carbon layers;
- one or more cobalt iron carbon boron layers;
- one or more cobalt boron layers.

6. The stack (10) of claim 5, wherein the free layer (14) comprises at least two layers with respectively an amorphising dopant, wherein the two layers have different contents of the amorphising dopant.

7. The stack (10) of one of the claims 1 to 6, wherein:
the free layer (14) has a [001] or [010] or [100] in-plane texture; and/or
the free layer (14) comprises one or more spacer material layers to enhance the [001] or [010] or [100] in-plane texture and/or to act as diffusion barrier.

8. The stack (10) of one of the claims 1 to 7, wherein:
the crystalline tunnel barrier layer (15) has a [001] or [010] or [100] in-plane texture; and/or
an interface between the crystalline tunnel barrier layer (15) and the free layer (14) is formed by a magnesium-oxide-layer to an iron-layer interface.

9. The stack (10) of one of the claims 1 to 8, wherein:
the free layer (14) and the reference layer (16) have each a thickness in a range of 0.1-3.0 nanometer; and/or
the seed metal layer (13) has a thickness in a range of 0.05-100 nanometer; and/or
the substrate layer (11) has a thickness in a range of 0.05-200 nanometer; and/or
the first electrode layer (12) has a thickness in a range of 1-200 nanometer; and/or
the crystalline tunnel barrier layer (15) has a thickness in a range of 0.5-5 nanometer.

10. The stack (10) of one of the claims 1 to 9, wherein the pinning layer (17) comprises a synthetic antiferromagnet layer, and optionally comprises a spacer layer (33) arranged on the reference layer (16).

11. A MRAM device comprising one or more stacks (10), wherein each stack (10) is designed according to the stack (10) of one of the claims 1 to 10.

12. A method (20) for fabricating a stack (10) for a magnetoresistive random-access memory, MRAM, device, the method (20) comprising:
forming (21) a substrate layer (11) having a [001] or [010] or [100] in-plane texture;
forming (22) a first electrode layer (12) on the substrate layer (11), the first electrode layer (12) having a [001] or [010] or [100] in-plane texture;
forming (23) a seed metal layer (13) on the first electrode layer (12), the seed metal layer (13) having a [001] or [010] or [100] in-plane texture;
forming (24) a magnetic free layer (14) on the seed metal layer (13);
forming (25) a tunnel barrier layer (15) on the free layer (14);
performing (26) a first anneal at a temperature in a range of 400-500 °C or higher, whereby the tunnel barrier layer (15) becomes crystalline;
forming (27) a magnetic reference layer (16) on the crystalline tunnel barrier layer (15), after performing (26) the first anneal;
forming (28) a pinning layer (17) on the reference layer (16); and
forming (29) a second electrode (18) layer on the pinning layer (17).

13. The method (20) of claim 12, wherein the method (20) further comprises performing (34) a second anneal at a temperature in a range of 300-400 °C or lower, after forming the second electrode layer (18).

14. The method (20) of claim 12 or 13, wherein the method (20) further comprises performing a third anneal after forming the seed layer (13) and before forming the free layer (14).

15. The method (20) of one of the claims 12 to 14, wherein the stack is designed according to the stack of one of the claims 2 to 10.

## Patentansprüche

1. Stapel (10) für eine magnetoresistive Direktzugriffsspeicher-, MRAM-, Vorrichtung, wobei der Stapel (10) umfasst:
eine Substratschicht (11) mit einer [001]- oder [010]- oder [100]-Inplane-Textur;
eine erste Elektrodenschicht (12), die auf der Substratschicht (11) angeordnet ist,
wobei die erste Elektrodenschicht (12) eine [001]- oder [010]- oder [1oo]-Inplane-Textur aufweist;
eine Keimmetallschicht (13), die auf der ersten Elektrodenschicht (12) angeordnet ist, wobei die Keimmetallschicht (13) eine [001]- oder [010]- oder [1oo]-Inplane-Textur aufweist;
eine magnetische freie Schicht (14), die auf der Keimmetallschicht (13) angeordnet ist;
eine kristalline Tunnelbarriereschicht (15), die auf der freien Schicht (14) angeordnet ist;
eine magnetische Referenzschicht (16), die auf der kristallinen Tunnelbarriereschicht (15) angeordnet ist;
eine Pinning-Schicht (17), die auf der Referenzschicht (16) angeordnet ist; und
eine zweite Elektrodenschicht (18), die auf der Pinning-Schicht (17) angeordnet ist.

2. Stapel (10) nach Anspruch 1, wobei:
die Substratschicht (11) mindestens eine von einer Magnesiumoxidschicht, einer auf Magnesiumoxid basierenden Schicht und einer leitfähigen oder dielektrischen [001]- oder [010]- oder [100]-Inplane-Schicht umfasst; und
die leitfähige oder dielektrische Schicht mindestens eine von einer Magnesiumtitanoxidschicht, einer Magnesiumtitanatschicht, einer Magnesiumdititanatschicht, einer Magnesiumgallatschicht und einer Nickelaluminidschicht umfasst.

3. Stapel (10) nach Anspruch 1 oder 2, wobei die erste Elektrodenschicht (11) mindestens eine von einer Titannitridschicht, einer Chromschicht, einer Tantalnitridschicht umfasst.

4. Stapel (10) nach einem der Ansprüche 1 bis 3, wobei:
die Keimmetallschicht (13) mindestens eine von einer Wolframschicht, einer Molybdänschicht, einer Niobnitridschicht und einer Tantalschicht umfasst.

5. Stapel (10) nach einem der Ansprüche 1 bis 4, wobei:
mindestens eine von der freien Schicht (14) und der Referenzschicht (16) eine Schicht auf Eisenbasis umfasst; und/oder
mindestens eine von der freien Schicht (14) und der Referenzschicht (16) mindestens eine der Folgenden umfasst:
- eine oder mehrere Eisenschichten;
- eine oder mehrere Eisenborschichten;
- eine oder mehrere Kobalteisenborschichten;
- eine oder mehrere Kobalteisenschichten;
- eine oder mehrere Kobalteisenkohlenstoffschichten;
- eine oder mehrere Kobalteisenkohlenstoffborschichten;
- eine oder mehrere Kobaltborschichten.

6. Stapel (10) nach Anspruch 5, wobei die freie Schicht (14) mindestens zwei Schichten mit jeweils einem amorphisierenden Dotierstoff umfasst, wobei die zwei Schichten unterschiedliche Gehalte des amorphisierenden Dotierstoffs aufweisen.

7. Stapel (10) nach einem der Ansprüche 1 bis 6, wobei:
die freie Schicht (14) eine [001]- oder [010]- oder [100]-Inplane-Textur aufweist; und/oder
die freie Schicht (14) eine oder mehrere Spacermaterialschichten aufweist, um die [001]- oder [010]- oder [100]-Inplane-Textur zu verbessern und/oder als Diffusionsbarriere zu wirken.

8. Stapel (10) nach einem der Ansprüche 1 bis 7, wobei:
die kristalline Tunnelbarriereschicht (15) eine [001]- oder [010]- oder [100]-Inplane-Textur aufweist; und/oder
eine Grenzfläche zwischen der kristallinen Tunnelbarriereschicht (15) und der freien Schicht (14) durch eine Grenzfläche einer Magnesiumoxidschicht zu einer Eisenschicht gebildet ist.

9. Stapel (10) nach einem der Ansprüche 1 bis 8, wobei:
die freie Schicht (14) und die Referenzschicht (16) jeweils eine Dicke in einem Bereich von 0,1-3,0 Nanometer aufweisen; und/oder
die Keimmetallschicht (13) eine Dicke in einem Bereich von 0,05-100 Nanometer aufweist; und/oder
die Substratschicht (11) eine Dicke in einem Bereich von 0,05-200 Nanometer aufweist; und/oder
die erste Elektrodenschicht (12) eine Dicke in einem Bereich von 1-200 Nanometer aufweist; und/oder
die kristalline Tunnelbarriereschicht (15) eine Dicke im Bereich von 0,5-5 Nanometer aufweist.

10. Stapel (10) nach einem der Ansprüche 1 bis 9, wobei die Pinning-Schicht (17) eine synthetische Antiferromagnetschicht umfasst und gegebenenfalls eine Spacerschicht (33) umfasst, die auf der Referenzschicht (16) angeordnet ist.

11. MRAM-Vorrichtung, die einen oder mehrere Stapel (10) umfasst, wobei jeder Stapel (10) gemäß dem Stapel (10) nach einem der Ansprüche 1 bis 10 konzipiert ist.

12. Verfahren (20) zum Fertigen eines Stapels (10) für eine magnetoresistive Direktzugriffsspeicher-, MRAM-, Vorrichtung, wobei das Verfahren (20) umfasst:
Bilden (21) einer Substratschicht (11) mit einer [001]- oder [010]- oder [100]-Inplane-Textur;
Bilden (22) einer ersten Elektrodenschicht (12) auf der Substratschicht (11), wobei die erste Elektrodenschicht (12) eine [001]- oder [010]- oder [100]-Inplane-Textur aufweist;
Bilden (23) einer Keimmetallschicht (13) auf der ersten Elektrodenschicht (12), wobei die Keimmetallschicht (13) eine [001]- oder [010]- oder [1oo]-Inplane-Textur aufweist;
Bilden (24) einer magnetischen freien Schicht (14) auf der Keimmetallschicht (13); Bilden (25) einer Tunnelbarriereschicht (15) auf der freien Schicht (14);
Durchführen (26) eines ersten Temperns bei einer Temperatur in einem Bereich von 400-500 °C oder höher, wodurch die Tunnelbarriereschicht (15) kristallin wird; Bilden (27) einer magnetischen Referenzschicht (16) auf der kristallinen Tunnelbarriereschicht (15) nach Durchführen (26) des ersten Temperns;
Bilden (28) einer Pinning-Schicht (17) auf der Referenzschicht (16); und
Bilden (29) einer zweiten Elektrodenschicht (18) auf der Pinning-Schicht (17).

13. Verfahren (20) nach Anspruch 12, wobei das Verfahren (20) ferner Durchführen (34) eines zweiten Temperns bei einer Temperatur in einem Bereich von 300-400 °C oder weniger nach dem Bilden der zweiten Elektrodenschicht (18) umfasst.

14. Verfahren (20) nach Anspruch 12 oder 13, wobei das Verfahren (20) ferner Durchführen eines dritten Temperns nach dem Bilden der Keimschicht (13) und vor dem Bilden der freien Schicht (14) umfasst.

15. Verfahren (20) nach einem der Ansprüche 12 bis 14, wobei der Stapel gemäß dem Stapel nach einem der Ansprüche 2 bis 10 konzipiert ist.

## Revendications

1. Empilement (10) pour un dispositif de mémoire vive magnétorésistive, MRAM, l'empilement (10) comprenant :
une couche de substrat (11) ayant une texture dans le plan [001] ou [010] ou [100] ;
une première couche d'électrode (12) disposée sur la couche de substrat (11), la première couche d'électrode (12) ayant une texture dans le plan [001] ou [010] ou [100] ;
une couche de germination métallique (13) disposée sur la première couche d'électrode (12), la couche de germination métallique (13) ayant une texture dans le plan [001] ou [010] ou [100] ;
une couche magnétique libre (14) disposée sur la couche de germination métallique (13) ;
une couche barrière à effet tunnel cristalline (15) disposée sur la couche libre (14) ; une couche de référence magnétique (16) disposée sur la couche barrière à effet tunnel cristalline (15) ;
une couche d'ancrage (17) disposée sur la couche de référence (16) ; et
une deuxième couche d'électrode (18) disposée sur la couche d'ancrage (17).

2. Empilement (10) selon la revendication 1, dans lequel :
la couche de substrat (11) comprend au moins une couche parmi une couche d'oxyde de magnésium, une couche à base d'oxyde de magnésium, et une couche conductrice ou diélectrique dans le plan [001] ou [010] ou [100] ; et
la couche conductrice ou diélectrique comprend au moins une couche parmi une couche d'oxyde de magnésium et de titane, une couche de titanate de magnésium, une couche de dititanate de magnésium, une couche de gallate de magnésium, et une couche d'aluminure de nickel.

3. Empilement (10) selon la revendication 1 ou 2, dans lequel la première couche d'électrode (11) comprend au moins une couche parmi une couche de nitrure de titane, une couche de chrome, une couche de nitrure de tantale.

4. Empilement (10) selon une des revendications 1 à 3, dans lequel :
la couche de germination métallique (13) comprend au moins une couche parmi une couche de tungstène, une couche de molybdène, une couche de nitrure de niobium, et une couche de tantale.

5. Empilement (10) selon une des revendications 1 à 4, dans lequel :
au moins une couche parmi la couche libre (14) et la couche de référence (16) comprend une couche à base de fer ; et/ou
au moins une couche parmi la couche libre (14) et la couche de référence (16) comprend au moins une des couches suivantes :
- une ou plusieurs couches de fer ;
- une ou plusieurs couches de fer-bore ;
- une ou plusieurs couches de cobalt-fer-bore ;
- une ou plusieurs couches de cobalt-fer ;
- une ou plusieurs couches de cobalt-fer-carbone ;
- une ou plusieurs couches de cobalt-fer-carbone-bore ;
- une ou plusieurs couches de cobalt-bore.

6. Empilement (10) selon la revendication 5, dans lequel la couche libre (14) comprend au moins deux couches avec respectivement un dopant amorphisant, les deux couches ayant des teneurs différentes du dopant amorphisant.

7. Empilement (10) selon une des revendications 1 à 6, dans lequel :
la couche libre (14) a une texture dans le plan [001] ou [010] ou [100] ; et/ou
la couche libre (14) comprend une ou plusieurs couches de matériau d'entretoise pour améliorer la texture dans le plan [001] ou [010] ou [100] et/ou pour agir comme barrière à la diffusion.

8. Empilement (10) selon une des revendications 1 à 7, dans lequel :
la couche barrière à effet tunnel cristalline (15) a une texture dans le plan [001] ou [010] ou [100] ; et/ou
une interface entre la couche barrière à effet tunnel cristalline (15) et la couche libre (14) est formée par une interface entre la couche d'oxyde de magnésium et la couche de fer.

9. Empilement (10) selon une des revendications 1 à 8, dans lequel :
la couche libre (14) et la couche de référence (16) ont chacune une épaisseur dans une plage de 0,1-3,0 nanomètres ; et/ou
la couche de germination métallique (13) a une épaisseur dans une plage de 0,05-100 nanomètres ; et/ou
la couche de substrat (11) a une épaisseur dans une plage de 0,05-200 nanomètres ; et/ou
la première couche d'électrode (12) a une épaisseur dans une plage de 1-200 nanomètres ; et/ou
la couche barrière à effet tunnel cristalline (15) a une épaisseur dans une plage de 0,5-5 nanomètres.

10. Empilement (10) selon une des revendications 1 à 9, dans lequel la couche d'ancrage (17) comprend une couche antiferromagnétique synthétique, et comprend éventuellement une couche d'entretoise (33) disposée sur la couche de référence (16).

11. Dispositif MRAM comprenant un ou plusieurs empilements (10), chaque empilement (10) étant conçu selon l'empilement (10) d'une des revendications 1 à 10.

12. Procédé (20) destiné à fabriquer un empilement (10) pour un dispositif de mémoire vive magnétorésistive, MRAM, le procédé (20) comprenant :
la formation (21) d'une couche de substrat (11) ayant une texture dans le plan [001] ou [010] ou [100] ;
la formation (22) d'une première couche d'électrode (12) sur la couche de substrat (11), la première couche d'électrode (12) ayant une texture dans le plan [001] ou [010] ou [100] ;
la formation (23) d'une couche de germination métallique (13) sur la première couche d'électrode (12), la couche de germination métallique (13) ayant une texture dans le plan [001] ou [010] ou [100] ;
la formation (24) d'une couche magnétique libre (14) sur la couche de germination métallique (13) ;
la formation (25) d'une couche barrière à effet tunnel (15) sur la couche libre (14) ;
la réalisation (26) d'un premier recuit à une température dans une plage de 400-500 °C ou plus, moyennant quoi la couche barrière à effet tunnel (15) devient cristalline ;
la formation (27) d'une couche de référence magnétique (16) sur la couche barrière à effet tunnel cristalline (15), après la réalisation (26) du premier recuit ;
la formation (28) d'une couche d'ancrage (17) sur la couche de référence (16) ; et
la formation (29) d'une deuxième couche d'électrode (18) sur la couche d'ancrage (17).

13. Procédé (20) selon la revendication 12, le procédé (20) comprenant en outre la réalisation (34) d'un deuxième recuit à une température dans une plage de 300-400 °C ou moins, après la formation de la deuxième couche d'électrode (18).

14. Procédé (20) selon la revendication 12 ou 13, le procédé (20) comprenant en outre la réalisation d'un troisième recuit après la formation de la couche de germination (13) et avant la formation de la couche libre (14).

15. Procédé (20) selon une des revendications 12 à 14, dans lequel l'empilement est conçu selon l'empilement d'une des revendications 2 à 10.
